# FASCICULE DE BREVET EUROPEEN

(11) **EP 3 319 920 B1**
(45) Date de publication et mention de la délivrance du brevet: **22.05.2019**
(21) Numéro de dépôt: 16750917.3
(22) Date de dépôt: 01.07.2016
(51) Int. Cl.: C03C 17/36

(54) **MATERAU COMPRENANT UN EMPILEMENT DE COUCHES MINCES**
MATERIAL MIT EINER VIELZAHL VON DÜNNEN SCHICHTEN
MATERIAL COMPRISING A STACK OF THIN LAYERS

(30) Priorité: 09.07.2015 FR 1556502
(43) Date de publication de la demande: 16.05.2018
(73) Titulaire: Saint-Gobain Glass France, 92400 Courbevoie (FR)
(72) Inventeur: SHI, Songlin, Shanghai 2626 (CN); GOUGOUSSIS, Christos, Nanjing 210041 (CN)
(74) Mandataire: Saint-Gobain Recherche
(86) Numéro de dépôt international: PCT/FR2016/051677
(87) Numéro de publication internationale: WO 2017/006034

(56) Documents cités:
- WO-A1-2011/062574
- US-A1- 2001 041 252
- US-A1- 2006 121 290
- US-A1- 2006 275 613

## Description

L'invention concerne un matériau et un procédé d'obtention d'un matériau, tel qu'un vitrage, comprenant un substrat transparent revêtu d'un empilement de couches minces comprenant une couche fonctionnelle à base d'argent.

Les couches fonctionnelles à base d'argent (ou couches d'argent) sont utiles à plusieurs titres : en réfléchissant le rayonnement infrarouge, thermique ou solaire, elles impartissent au matériau des fonctions de basse émissivité ou de contrôle solaire. Conductrices de l'électricité, elles permettent également d'obtenir des matériaux conducteurs, par exemple des vitrages chauffants ou des électrodes.

Les couches fonctionnelles à base d'argent sont déposées entre des revêtements à base de matériaux diélectriques (ci-après revêtements diélectriques) qui comprennent généralement plusieurs couches diélectriques permettant d'ajuster les propriétés optiques de l'empilement. Ces couches diélectriques permettent en outre de protéger la couche d'argent des agressions chimiques ou mécaniques. Les documents WO 2011/062574, US2001/041252, US 2006/275613 et US 2006/121290 décrivent tels empilements.

Fréquemment, de tels matériaux doivent subir des traitements thermiques, destinés à améliorer les propriétés du substrat et/ou de l'empilement de couches minces. Il peut par exemple s'agir, dans le cas de substrats en verre, de traitement de trempe thermique destinés à renforcer mécaniquement le substrat en créant de fortes contraintes de compression à sa surface. De tels traitements peuvent modifier certaines propriétés de l'empilement, notamment les performances thermiques, les propriétés optiques et électriques.

L'invention concerne tout particulièrement un matériau devant subir un traitement thermique à température élevée tel qu'un recuit, un bombage et/ou une trempe.

Les propriétés des empilements à base d'argent, tels que les performances énergétiques ou optiques résultent également d'un contrôle précis des effets d'interférences optiques entre les différentes couches composant l'empilement.

Il est connu d'utiliser des couches de blocage dont la fonction est de protéger en évitant une éventuelle dégradation de la couche d'argent liée au dépôt d'un revêtement diélectrique ou liée à un traitement thermique. De nombreuses possibilités variant notamment par la nature, le nombre et la position desdites couches de blocage ont été proposées.

Par exemple, il est possible d'utiliser une couche de blocage ou un revêtement de blocage constitué de plusieurs couches de blocage. Ces couches ou revêtements de blocage peuvent être situés uniquement au-dessus, uniquement en-dessous ou à la fois au-dessus et en-dessous de la couche fonctionnelle.

Les couches de blocage sont généralement à base d'un métal choisi parmi le nickel, le chrome, le titane, le niobium, ou d'un alliage de ces différents métaux. Les différents métaux ou alliages cités peuvent également être partiellement oxydés, notamment présenter une sous-stoechiométrie en oxygène (par exemple TiOₓ ou NiCrOₓ).

Ces couches de blocage sont très fines, normalement d'une épaisseur inférieure à 1 nm et sont susceptibles à ces épaisseurs d'être partiellement oxydées pendant un traitement thermique.

D'une manière générale, ces couches de blocage sont des couches sacrificielles, susceptibles de capter l'oxygène provenant de l'atmosphère ou du substrat, évitant ainsi l'oxydation de la couche d'argent.

Le choix de la nature et de l'épaisseur des couches de blocage est fonction des matériaux constituant la couche fonctionnelle, des matériaux constituant les revêtements diélectriques situés au contact de la couche fonctionnelle, des éventuels traitements thermiques et des propriétés recherchées.

La complexité des empilements ainsi que la diversité des traitements et des propriétés recherchées rendent nécessaire d'adapter les caractéristiques de la couche de blocage à chaque configuration. Dans la plupart des cas, le compromis pour obtenir certaines propriétés avant et après traitement thermique est difficile à trouver. Cela limite considérablement le choix des couches de blocage (nature et épaisseur).

Enfin, lorsque ces matériaux sont utilisés comme vitrages, selon les climats des pays où ils sont installés, les performances recherchées en termes de transmission lumineuse et de facteur solaire, peuvent varier dans une certaine gamme.

Dans les pays où les niveaux d'ensoleillement sont élevés, il existe une demande forte de vitrage présentant une transmission lumineuse de l'ordre de 40 % et des valeurs de facteur solaire inférieures à 0,33, de préférence inférieures à 0,31. La transmission lumineuse est alors suffisamment faible pour supprimer l'éblouissement et suffisamment élevée pour que la diminution de la quantité de lumière pénétrant à l'intérieur de l'espace délimité par ledit vitrage ne rende pas obligatoire l'utilisation de la lumière artificielle.

Des matériaux comprenant des couches fonctionnelles à base d'argent permettent d'obtenir des valeurs de transmission lumineuse et de facteur solaire dans les gammes recherchées. Cependant, l'aspect esthétique et les propriétés de réflexion de tels vitrages ne donnent pas entière satisfaction. Il existe actuellement une forte demande pour des vitrages présentant à la fois des couleurs en transmission neutres et un aspect argent brillant en réflexion extérieure sans altérer les performances solaire notamment sans augmenter le facteur solaire (g).

Selon l'invention, on entend par facteur solaire « g », le rapport entre l'énergie totale entrant dans le local à travers le vitrage et l'énergie solaire incidente.

Il existe donc un besoin de développer un matériau permettant :
- d'obtenir un aspect argent brillant en réflexion,
- d'améliorer la neutralité en transmission tout en gardant une transmission lumineuse adaptée pour permettre une bonne isolation et une bonne vision,
- d'augmenter sélectivement la réflexion côté extérieur, c'est-à-dire sans augmenter la réflexion intérieure,
- de minimiser le facteur solaire.

Le demandeur a découvert qu'un aspect brillant argent en réflexion, des couleurs neutres en transmission et une réflexion extérieure élevée notamment supérieure à 30 %, peuvent être obtenus grâce à l'utilisation d'un matériau comprenant un substrat transparent revêtu d'un empilement de couches minces particulier, notamment lorsque le matériau est monté dans un vitrage avec l'empilement positionné en face 2.

De manière conventionnelle, les faces d'un vitrage sont désignées à partir de l'extérieur du bâtiment et en numérotant les faces des substrats de l'extérieur vers l'intérieur de l'habitacle ou du local qu'il équipe. Cela signifie que la lumière solaire incidente traverse les faces dans l'ordre croissant de leur numéro.

La solution de l'invention représente un compromis entre les performances optiques, thermiques, la transparence et l'aspect esthétique.

L'invention a pour objet un matériau tel que défini dans la revendication 1. Ce matériau comprend un substrat transparent revêtu d'un empilement de couches minces comprenant une seule couche métallique fonctionnelle à base d'argent, l'empilement comprenant en partant du substrat :
- un revêtement diélectrique comportant au moins une couche diélectrique,
- éventuellement une couche de blocage inférieure située en-dessous et au contact de la couche métallique fonctionnelle à base d'argent,
- une couche métallique fonctionnelle à base d'argent,
- une couche de blocage supérieure située au-dessus et au contact de la couche métallique fonctionnelle à base d'argent,
caractérisé en ce que :
- l'épaisseur du revêtement diélectrique situé en-dessous de la couche métallique fonctionnelle à base d'argent est inférieure à 30 nm,
- la couche de blocage supérieure est une couche à base de nickel Ni et/ou de chrome Cr et présente une épaisseur supérieure à 2,0 nm,
- l'épaisseur de la couche de blocage supérieure est supérieure ou égale à l'épaisseur de la couche de blocage inférieure si une telle couche est présente,
- la somme des épaisseurs de la ou des couches de blocage à base de nickel et/ou de chrome situées directement au-contact de la couche fonctionnelle à base d'argent est comprise entre 3,0 et 10,0 nm.

L'invention concerne également :
- le procédé d'obtention d'un matériau selon l'invention,
- le vitrage comprenant au moins un matériau selon l'invention,
- l'utilisation d'un vitrage selon l'invention en tant que vitrage de contrôle solaire pour le bâtiment ou les véhicules,
- un bâtiment ou un véhicule comprenant un vitrage selon l'invention.

Les caractéristiques préférées qui figurent dans la suite de la description sont applicables aussi bien au procédé selon l'invention que, le cas échéant, aux produit, c'est-à-dire aux matériaux ou aux vitrages comprenant le matériau.

Le matériau, c'est-à-dire le substrat transparent revêtu de l'empilement, est destiné à subir un traitement thermique à température élevée de type trempe, recuit ou bombage.

Le choix d'une couche de blocage épaisse située au-dessus de la couche fonctionnelle à base d'argent combiné avec le choix d'un revêtement diélectrique de faible épaisseur situé en-dessous de la couche fonctionnelle à base d'argent, permet d'obtenir les propriétés recherchées.

L'empilement est de préférence positionné dans le vitrage de sorte que la lumière incidente provenant de l'extérieur traverse le premier revêtement diélectrique avant de traverser la première couche métallique fonctionnelle. La lumière incidente provenant de l'extérieur traverse donc dans cet ordre, le substrat, la couche métallique fonctionnelle à base d'argent, la couche de blocage épaisse situé au-dessus de la couche métallique fonctionnelle à base d'argent. L'empilement n'est pas déposé sur la face du substrat définissant la paroi extérieure du vitrage mais sur la face intérieure de ce substrat.

L'empilement est donc avantageusement positionné en face 2, la face 1 du vitrage étant la face la plus à l'extérieur du vitrage, comme habituellement.

En choisissant de monter de cette façon le vitrage, la couche de blocage épaisse n'est pas située entre l'extérieur et la couche fonctionnelle à base d'argent. Un rayon traversant le substrat venant de l'extérieur est plus facilement réfléchi par la couche d'argent alors qu'un rayon traversant le substrat venant de l'intérieur est plus facilement absorbé par la couche de blocage épaisse, directement ou après réflexion par la couche d'argent. Il semble de manière surprenante, qu'une telle couche de blocage, placée à cet endroit combiné à la présence d'un revêtement diélectrique inférieur fin, permet d'obtenir la combinaison des propriétés recherchées et notamment une réflexion extérieure élevée, un aspect argent brillant en réflexion extérieure, des couleurs neutres en transmission tout en maintenant les excellentes performances énergétiques et sans nécessiter de modifications substantielles des autres paramètres de l'empilement tels que la nature et la séquence des couches le constituant.

Ces propriétés avantageuses sont a fortiori obtenues lorsque l'épaisseur du revêtement diélectrique situé en-dessous de la couche métallique fonctionnelle à base d'argent est inférieure à 30 nm, de préférence inférieure à 20 nm, voire inférieure à 15 nm.

Selon un mode de réalisation, le matériau selon l'invention est trempable en ce que les valeurs de transmission lumineuse et de facteur solaire ne sont pas substantiellement modifiées lors du traitement thermique.

L'avantage majeur de l'invention est que l'obtention de l'aspect visuel satisfaisant avec notamment des couleurs en réflexion extérieure et en transmission esthétiquement acceptables ainsi que des valeurs de réflexion extérieure suffisamment élevées ne s'opèrent pas au détriment des performances de protection solaire.

Toutes les caractéristiques lumineuses présentées dans la présente description sont obtenues selon les principes et méthodes décrits dans la norme européenne EN 410 se rapportant à la détermination des caractéristiques lumineuses et solaires des vitrages utilisés dans le verre pour la construction.

Le matériau selon l'invention, utilisé comme vitrage monolithique ou dans un vitrage multiple de type double-vitrage, présente des couleurs en réflexion extérieure neutres, agréables et douces, dans la gamme des bleus ou bleus-verts (valeurs de longueur d'onde dominante de l'ordre de 470 à 500 nanomètres). Par « couleur dans le bleu-vert » au sens de la présente invention, il faut comprendre que dans le système de mesure de couleur L*a*b*, a* est compris entre -10,0 et 0,0, de préférence entre - 7,0 et 0,0 et b* est compris entre -10,0 et 0,0, de préférence entre -7,0 et 0,0.

Le vitrage de l'invention présente des couleurs en réflexion côté extérieur dans le système de mesure de couleur L*a*b* telles que :
- a*Rext compris entre -5,0 et 0,0, de préférence entre -2,0 et -1,5 et/ou
- b*Rext compris entre -7,0 et 0,0, de préférence entre -6,0 et -5,0.

Le vitrage de l'invention présente des couleurs en transmission dans le système de mesure de couleur L*a*b* telles que :
- a*T compris entre -8,0 et 0,0, de préférence entre -5,0 et -1,0 et/ou
- b*T est compris entre -7,0 et 0,0, de préférence entre -3,0 et -1,0.

De préférence, l'empilement est déposé par pulvérisation cathodique assistée par un champ magnétique (procédé magnétron). Selon ce mode de réalisation avantageux, toutes les couches de l'empilement sont déposées par pulvérisation cathodique assistée par un champ magnétique.

L'invention concerne également le procédé d'obtention d'un matériau selon l'invention, dans lequel on dépose les couches de l'empilement par pulvérisation cathodique magnétron.

Sauf mention contraire, les épaisseurs évoquées dans le présent document sont des épaisseurs physiques et les couches sont des couches minces. On entend par couche mince, une couche présentant une épaisseur comprise entre 0,1 nm et 100 micromètres.

Dans toute la description le substrat selon l'invention est considéré posé horizontalement. L'empilement de couches minces est déposé au-dessus du substrat. Le sens des expressions « au-dessus » et « en-dessous » et « inférieur » et « supérieur » est à considérer par rapport à cette orientation. A défaut de stipulation spécifique, les expressions « au-dessus » et « en-dessous » ne signifient pas nécessairement que deux couches et/ou revêtements sont disposés au contact l'un de l'autre. Lorsqu'il est précisé qu'une couche est déposée « au contact » d'une autre couche ou d'un revêtement, cela signifie qu'il ne peut y avoir une ou plusieurs couches intercalées entre ces deux couches.

Les couches de blocage à base de nickel et/ou de chrome peuvent être choisies parmi les couches métalliques, les couches de nitrure métallique, les couches d'oxyde métallique et les couches d'oxynitrure métallique. Lorsque ces couches de blocage sont déposées sous forme métallique, nitrurée ou oxynitrurée, ces couches peuvent subir une oxydation partielle ou totale selon leur épaisseur et la nature des couches qui les entourent, par exemple, au moment du dépôt de la couche suivante ou par oxydation au contact de la couche sous-jacente. De préférence, les couches de blocage à base de nickel et/ou de chrome sont des couches métalliques ou des couches d'oxyde métallique, de préférence, sous stoechiométrique en oxygène.

Les couches de blocage à base de nickel et/ou de chrome, comprennent, par ordre de préférence croissant, en masse par rapport à la masse totale de nickel et de chrome dans la couche de blocage :
- 50 à 100 %, 60 à 90 %, 65 à 85 % de nickel et
- 0 à 50 %, 10 à 40 %, 15 à 35 % de chrome.

Les couches de blocage à base de nickel et/ou de chrome, comprennent, par ordre de préférence croissant, en masse par rapport à la masse totale de la couche de blocage, au moins 50 %, au moins 60 %, au moins 70 %, au moins 80 %, au moins 90 %, au moins 95 %, au moins 96 %, au moins 97 %, au moins 98 %, au moins 99 %, 100 % de nickel et/ou de chrome.

Avantageusement, la couche de blocage supérieure à base de nickel et/ou de chrome est essentiellement métallique, c'est-à-dire qu'elle comprend au moins 95 %, en masse de nickel et/ou de chrome par rapport à la masse totale de la couche de blocage. Une couche comprenant 100 % de nickel et/ou de chrome correspond à une couche complétement métallique.

L'empilement peut comprendre une couche de blocage située en-dessous et au-contact de la couche métallique fonctionnelle à base d'argent. Cette couche de blocage inférieure peut être choisie parmi les couches à base de nickel et/ou de chrome. De préférence, la couche de blocage inférieure à base de nickel et/ou de chrome est essentiellement métallique, c'est-à-dire qu'elle comprend au moins 95 %, en masse de nickel et/ou de chrome par rapport à la masse totale de la couche de blocage.

De préférence, les couches de blocage à base de nickel et/ou de chrome comprennent au moins 95 %, en masse de nickel et/ou de chrome par rapport à la masse totale de la couche de blocage.

La couche de blocage supérieure selon l'invention présente, par ordre de préférence croissant, une épaisseur :
- d'au moins 2,1 nm, d'au moins 2,5 nm, d'au moins 3,0, d'au moins 3,5 nm, d'au moins 4,0 nm et/ou
- d'au plus 8,0 nm ou d'au plus 7,0 nm, d'au plus 6,0 nm, d'au plus 5,0 nm.

La couche de blocage supérieure présente une épaisseur comprise entre 2,1 et 6,0 nm, de préférence 3,0 et 5,0 nm.

La couche de blocage inférieure selon l'invention présente, par ordre de préférence croissant, une épaisseur:
- d'au moins 0,5 nm, d'au moins 0,8 nm, d'au moins 1,0, d'au moins 1,5 et/ou
- d'au plus 2,5 nm, d'au plus 2,0 nm, d'au plus 1,5 nm.

La couche de blocage inférieure présente, par ordre de préférence croissant, une épaisseur comprise entre 0,5 et 2,5 nm, entre 0,5 et 2,0 nm, entre 0,8 et 1,5 nm.

L'épaisseur de la couche de blocage supérieure est d'au moins 10 %, de préférence d'au moins 20 % plus épaisse que la couche de blocage inférieure. Le rapport de l'épaisseur de la couche de blocage supérieure sur l'épaisseur de la couche de blocage inférieure est par ordre de préférence croissant, supérieur à 1,1, supérieur à 1,5, supérieur à 2,0, supérieur à 2,5, supérieur à 3,0, supérieur à 3,5.

La somme des épaisseurs de la ou des couches de blocage à base de nickel et/ou chrome situées directement au-contact de la couche fonctionnelle à base d'argent est comprise entre 3,0 et 10,0 nm, de préférence comprise entre 4,0 et 8,0 nm, voire comprise entre 4,0 et 6,0 nm.

La couche fonctionnelle métallique à base d'argent comprend au moins 95,0 %, de préférence au moins 96,5 % et mieux au moins 98,0 % en masse d'argent par rapport à la masse de la couche fonctionnelle. De préférence, la couche métallique fonctionnelle à base d'argent comprend moins de 1,0 % en masse de métaux autres que de l'argent par rapport à la masse de la couche métallique fonctionnelle à base d'argent.

La couche métallique fonctionnelle à base d'argent présente, par ordre de préférence croissant, une épaisseur supérieure à 10 nm, comprise entre 12 et 20 nm, compris entre 14 et 18 nm.

Les couches diélectriques des revêtements diélectriques présentent les caractéristiques suivantes seules ou en combinaison :
- elles sont déposées par pulvérisation cathodique assistée par champ magnétique,
- elles sont choisies parmi les oxydes ou nitrures d'un ou plusieurs éléments choisi(s) parmi le titane, le silicium, le zirconium, l'aluminium, l'étain et le zinc,
- elles ont une épaisseur supérieure ou égale à 5 nm, de préférence comprise entre 8 et 35 nm.

Les couches diélectriques peuvent être des couches à fonction barrière, c'est-à-dire une couche en un matériau apte à faire barrière à la diffusion de l'oxygène et de l'eau à haute température, provenant de l'atmosphère ambiante ou du substrat transparent, vers la couche fonctionnelle. Les couches diélectriques à fonction barrière peuvent être à base de composés de silicium et/ou d'aluminium choisis parmi les oxydes tels que SiO₂, les nitrures tels que les nitrure de silicium Si₃N₄ et les nitrures d'aluminium AIN, et les oxynitrures SiOₓN_{y}, éventuellement dopé à l'aide d'au moins un autre élément.

Selon un mode de réalisation avantageux, le revêtement diélectrique situé en-dessous et/ou au-dessus de la couche métallique fonctionnelle à base d'argent comprend au moins une couche diélectrique à base de nitrure ou d'un oxynitrure de silicium et/ou d'aluminium.

L'épaisseur du revêtement diélectrique situé en-dessous de la couche métallique fonctionnelle à base d'argent est inférieure à 30 nm, de préférence inférieure à 20 nm, voire inférieure à 15 nm.

L'épaisseur du revêtement diélectrique situé au-dessus de la couche métallique fonctionnelle à base d'argent est supérieure à 30 nm, de préférence supérieure à 40 nm, voire inférieure à 45 nm.

Le revêtement diélectrique situé en-dessous de la couche métallique fonctionnelle à base d'argent peut notamment comporter une seule couche constituée d'un nitrure ou d'un oxynitrure d'aluminium et/ou de silicium, d'épaisseur comprise entre 10 et 30 nm.

L'empilement peut comprendre une couche de protection. La couche de protection est de préférence la dernière couche de l'empilement, c'est-à-dire la couche la plus éloignée du substrat revêtu de l'empilement (avant traitement thermique). Ces couches sont en général une épaisseur comprise entre 2 et 5 nm. Cette couche de protection peut être choisie parmi une couche de titane, de zirconium, d'hafnium, de zinc et/ou d'étain, ce ou ces métaux étant sous forme métallique, oxydée ou nitrurée.

Selon un mode de réalisation, la couche de protection est à base d'oxyde de titane.

Un exemple d'empilement convenant selon l'invention comprend :
- un revêtement diélectrique situé en-dessous de la couche métallique fonctionnelle à base d'argent comprenant au moins une couche diélectrique à base de nitrure de silicium et/ou d'aluminium,
- une couche métallique fonctionnelle à base d'argent,
- une couche de blocage,
- un revêtement diélectrique situé au-dessus de la couche métallique fonctionnelle à base d'argent comprenant au moins une couche diélectrique à base de nitrure de silicium et/ou d'aluminium,
- éventuellement une couche de protection.

Les substrats transparents selon l'invention sont de préférence en un matériau rigide minéral, comme en verre, ou organiques à base de polymères (ou en polymère).

Les substrats transparents organiques selon l'invention peuvent également être en polymère, rigides ou flexibles. Des exemples de polymères convenant selon l'invention comprennent, notamment :
- le polyéthylène,
- les polyesters tels que le polyéthylène téréphtalate (PET), le polybutylène téréphtalate (PBT), le polyéthylène naphtalate (PEN) ;
- les polyacrylates tels que le polyméthacrylate de méthyle (PMMA) ;
- les polycarbonates ;
- les polyuréthanes ;
- les polyamides ;
- les polyimides ;
- les polymères fluorés comme les fluoroesters tels que l'éthylène tétrafluoroéthylène (ETFE), le polyfluorure de vinylidène (PVDF), le polychlorotrifluorethylène (PCTFE), l'éthylène de chlorotrifluorethylène (ECTFE), les copolymères éthylène-propylène fluores (FEP) ;
- les résines photoréticulables et/ou photopolymérisables, telles que les résines thiolène, polyuréthane, uréthane-acrylate, polyester-acrylate et
- les polythiouréthanes.

Le substrat est de préférence une feuille de verre ou de vitrocéramique.

Le substrat est de préférence transparent, incolore (il s'agit alors d'un verre clair ou extra-clair) ou coloré, par exemple en bleu, gris ou bronze. Le verre est de préférence de type silico-sodo-calcique, mais il peut également être en verre de type borosilicate ou alumino-borosilicate.

Le substrat possède avantageusement au moins une dimension supérieure ou égale à 1 m, voire 2 m et même 3 m. L'épaisseur du substrat varie généralement entre 0,5 mm et 19 mm, de préférence entre 0,7 et 9 mm, notamment entre 2 et 8 mm, voire entre 4 et 6 mm. Le substrat peut être plan ou bombé, voire flexible.

Le matériau, c'est-à-dire le substrat transparent revêtu de l'empilement, est destiné à subir un traitement thermique à température élevée choisi parmi un recuit, par exemple par un recuit flash tel qu'un recuit laser ou flammage, une trempe et/ou un bombage. La température du traitement thermique est supérieure à 400 °C, de préférence supérieure à 450 °C, et mieux supérieure à 500 °C. Le substrat revêtu de l'empilement peut donc être bombé et/ou trempé.

Le matériau peut être sous forme de vitrage monolithique, de vitrage feuilleté ou d'un vitrage multiple notamment un double-vitrage ou un triple vitrage.

L'invention concerne également un procédé de préparation du matériau. Le procédé comprendre en outre l'étape pendant laquelle on fait subir un traitement thermique au substrat ainsi revêtu. Ce traitement thermique peut être réalisé à une température supérieure à 300 °C ou supérieure à 400 °C, de préférence supérieure 500 °C. Le traitement thermique est de préférence choisi parmi les traitements de trempe, de recuit, de recuit rapide.

Le traitement de trempe ou de recuit est généralement mis en oeuvre dans un four, respectivement de trempe ou de recuisson. L'intégralité du matériau, y compris donc le substrat, est portée à une température élevée, d'au moins 300°C dans le cas de la recuisson, et d'au moins 500°C, voire 600°C, dans le cas d'une trempe.

L'invention concerne également un vitrage comprenant le matériau selon l'invention. Le vitrage peut être choisi parmi un vitrage monolithique, feuilleté ou multiple, en particulier double vitrage ou triple vitrage.

Un vitrage feuilleté comprend au moins deux substrats rigides du type verre assemblés par au moins une feuille de polymère thermoplastique.

Un vitrage multiple comprend au moins deux substrats maintenus à distance de manière à délimiter une cavité remplie par un gaz isolant.

Dans le cas d'un vitrage monolithique ou multiple, l'empilement est de préférence déposé en face 2, c'est-à-dire qu'il se trouve sur le substrat définissant la paroi extérieure du vitrage et plus précisément sur la face intérieure de ce substrat.

Un vitrage monolithique comporte 2 faces, la face 1 est à l'extérieur du bâtiment et constitue donc la paroi extérieure du vitrage, la face 2 est à l'intérieur du bâtiment et constitue donc la paroi intérieure du vitrage.

Un double vitrage comporte 4 faces, la face 1 est à l'extérieur du bâtiment et constitue donc la paroi extérieure du vitrage, la face 4 est à l'intérieur du bâtiment et constitue donc la paroi intérieure du vitrage, les faces 2 et 3 étant à l'intérieur du double vitrage.

De la même manière, un triple vitrage comporte 6 faces, la face 1 est à l'extérieur du bâtiment (paroi extérieure du vitrage), la face 6 à l'intérieur du bâtiment (paroi intérieure du vitrage) et les faces 2 à 5 sont à l'intérieur du triple vitrage.

Selon des modes de réalisation avantageux, le matériau selon l'invention présente :
- une transmission lumineuse inférieure à 50 %, de préférence comprise entre 35 et 50 %, voire comprise entre 40 et 45 % et/ou
- une réflexion lumineuse côté extérieur supérieure à 30 %, de préférence supérieure à 35 %.

Le vitrage de l'invention sous forme d'un double vitrage comprenant l'empilement positionné en face 2 permet d'atteindre notamment les performances suivantes :
- un facteur solaire g inférieur à 0,30,
- une transmission lumineuse comprise entre 35 % et 50 %, de préférence d'environ 40 %,
- une réflexion extérieure supérieure à 30 %, de préférence supérieure à 32 %,
- des couleurs neutres en transmission.

Un vitrage feuilleté comporte au moins une structure de type premier substrat / feuille(s) / deuxième substrat. L'empilement de couches minces est positionné sur l'une au moins des faces d'un des substrats. L'empilement peut être sur la face du deuxième substrat non au contact de la feuille polymère. Ce mode de réalisation est avantageux lorsque le vitrage feuilleté est monté en double vitrage avec un troisième substrat.

Les exemples qui suivent illustrent l'invention sans toutefois la limiter.

### Exemples

### I. Description des empilements

Des empilements de couches minces définis ci-après sont déposés sur des substrats en verre sodo-calcique clair d'une épaisseur de 6 mm, de manière connue, sur une ligne de pulvérisation cathodique (procédé magnétron) dans laquelle le substrat vient défiler sous différentes cibles.

Dans les exemples de l'invention :
- les couches fonctionnelles sont des couches d'argent (Ag),
- les couches de blocage sont des couches métalliques en alliage de nickel et de chrome (NiCr),
- les couches barrières sont à base de nitrure de silicium, dopé à l'aluminium (Si₃N₄ : Al).

Pour ces exemples, les conditions de dépôt des couches déposées par pulvérisation (pulvérisation dite « cathodique magnétron ») sont résumées dans le tableau 1.

| **Tab.1** | Cible employée | Pression de dépôt | Gaz | Indice 550 nm |
|---|---|---|---|---|
| Si₃N₄ | Si:Al à 92:8 % en poids | 1,5.10⁻³ mbar | Ar/(Ar+N2) à 55 % | 2,00-2,10 |
| NiCr | Ni (80% at.) : Cr (20% at.) | 2.10⁻³ mbar | Ar à 100 % | - |
| Ag | Ag | 8.10⁻³ mbar | Ar à 100 % | - |
| TiO₂ | TiOx | 1,5.10⁻³ mbar | Ar 88 % - O₂ 12% | 2,32 |

| | | | | |
|---|---|---|---|---|
| at. : atomique ; pds : poids ; Indice : à 550 nm. | | | | |

Le tableau 2 liste les matériaux et les épaisseurs physiques en nanomètres (sauf autre indication) de chaque couche ou revêtement qui constitue les empilements en fonction de leurs positions vis-à-vis du substrat porteur de l'empilement (dernière ligne en bas du tableau). Les épaisseurs données dans le tableau 1 correspondent aux épaisseurs avant trempe.

Les substrats subissent une trempe thermique dans les conditions suivantes : traitement thermique pendant 5 à 15 minutes à une température comprise entre 600 et 750°C.

| **Tab. 2** | | **Comparatifs** | | | | **Invention** | | |
|---|---|---|---|---|---|---|---|---|
| Matériau | | Cmp.1 | Cmp.2 | Cmp.3 | Cmp.4 | Mat.1 | Mat.2 | Mat.3 |
| RD | TiO₂ Si₃N₄ | 2 50,1 | 2 47,5 | 2 47,5 | 2 47,5 | 2 47,5 | 2 47 | 2 47,5 |
| CB Sup. | NiCr | 1,7 | 1,0 | 2,0 | 2,5 | 3,9 | 4 | 2,5 |
| CF | Ag | 18,8 | 16 | 16 | 16 | 16 | 16 | 16 |
| CB Inf. | NiCr | 3,6 | 3,0 | 3,0 | 3,9 | 1,0 | 1,0 | 2,5 |
| RD | Si₃N₄ | 31,3 | 14,2 | 14,2 | 14,2 | 14,2 | 15,1 | 14,2 |
| Substrat (mm) | verre | 6 | 6 | 6 | 6 | 6 | 6 | 6 |
| CB Sup./ CB Inf. | - | 0,5 | 0,3 | 0,7 | 0,6 | 3,9 | 4 | 1,0 |

| | | | | | | | | |
|---|---|---|---|---|---|---|---|---|
| CB : Couche de blocage ; CF : Couche fonctionnelle ; RD : Revêtement diélectrique. | | | | | | | | |

### II. Performances énergétiques des vitrages

Le tableau 3 liste les principales caractéristiques optiques mesurées en double vitrage présentant un structure 6/12/6 : verre de 6 mm / espace intercalaire de 12 mm rempli d'air / verre de 6 mm, l'empilement étant positionné en face 2 (la face 1 du vitrage étant la face la plus à l'extérieur du vitrage, comme habituellement).

Dans ce tableau :
- TL indique : la transmission lumineuse dans le visible en %, mesurée selon l'illuminant D65 à 2° Observateur ;
- RLext indique : la réflexion lumineuse dans le visible en %, mesurée selon l'illuminant D65 à 2° Observateur du côté de la face la plus à l'extérieur, la face 1 ;
- RLint indique : la réflexion lumineuse dans le visible en %, mesurée selon l'illuminant D65 à 2° Observateur du côté de la face la plus à l'intérieure, la face 2 dans le cas d'un simple vitrage ;
- TE indique : la transmission énergétique correspondant au rapport du flux énergétique transmis sur le flux énergétique incident en %, mesurée pour des longueurs d'onde comprises entre 0,3 et 2,5 µm selon l'illuminant D65 à 2° Observateur ;
- REext indique : la réflexion énergétique correspondant au rapport du flux énergétique réfléchi sur le flux énergétique incident en %, mesurée pour des longueurs d'onde comprises entre 0,3 et 2,5 µm selon l'illuminant D65 à 2° Observateur du côté de la face la plus à l'extérieur, la face 1 ;
- L*T, a*T et b*T indiquent les couleurs en transmission L*, a* et b* dans le système L*a*b* mesurées selon l'illuminant D65 à 2° Observateur et mesurées perpendiculairement au vitrage ;
- L*Rext, a*Rext et b*Rext indiquent les couleurs en réflexion a* et b* dans le système L*a*b* mesurées selon l'illuminant D65 à 2° Observateur du côté de la face la plus à l'extérieur et mesurées ainsi perpendiculairement au vitrage.

| **Tab.3** | Val. cible | Cmp.1 | Cmp.2 | Cmp.3 | Cmp.4 | Mat.1 | Mat.3 |
|---|---|---|---|---|---|---|---|
| g | < 0,31 | 0,31 | **0,33** | 0,31 | 0,26 | 0,30 | 0,31 |
| TL% | ≈40 | 44 | 43,3 | 41,0 | 36,2 | 40,2 | 40,7 |
| RLext% | >33 | **31** | 36,5 | 35,0 | 38,5 | 38,4 | 35,8 |
| RLint% | - | 22 | 18,6 | 19,9 | 18,2 | 17,8 | 19,3 |
| TE% | - | 25 | 27 | 25,3 | 22,6 | 24,9 | 25,2 |
| REext% | - | 36 | 38,9 | 37,2 | 39,1 | 39,8 | 37,9 |
| - L*T | - | 72,2 | 71,8 | 70,2 | 66,6 | 69,5 | 69,9 |
| - a*T | -5 à 0 | -4,40 | -4,70 | -5,0 | -4,8 | -4,7 | -4,9 |
| - b*T | -3 à 0 | **+1,0** | -0,60 | **0,3** | -0,6 | -1,1 | 0,0 |
| - L*Rext | - | 63,0 | 67,0 | 65,7 | 68,6 | 68,5 | 66,4 |
| - a*Rext | -2 à -1,5 | -1,40 | -1,6 | -2,0 | -2,1 | -1,8 | -1,9 |
| - b*Rext | -6 à -5 | -2,4 | -6,3 | -5,6 | -4,2 | -5,5 | -5,5 |
| CB1 ≥ CB2 | oui | non | non | non | non | oui | non |
| CB1+CB2 | 4,5-6,0 | 5,3 | 4,0 | 5,0 | 6,4 | 4,9 | 5,0 |

Selon l'invention, il est possible de réaliser un vitrage comprenant un empilement comportant une couche fonctionnelle métallique qui présente une transmission lumineuse d'environ 40 %, une réflexion lumineuse extérieure élevée et un facteur solaire faible ainsi qu'un excellent compromis pour les couleurs en transmission et en réflexion extérieure.

L'utilisation du matériau dans un double vitrage monté de sorte que le substrat correspondant à la paroi extérieure comprenne en face 2 l'empilement concourt à l'obtention de ces meilleurs résultats.

Les exemples selon l'invention présentent tous une coloration en transmission agréable et douce, de préférence, dans la gamme des bleus ou bleus-verts.

Les exemples comparatifs ne présentent pas des valeurs de facteur solaire inférieures ou égales à 0,31 et/ou une réflexion extérieure supérieure à 35 et/ou un aspect argent brillant en réflexion extérieure et/ou des couleurs neutres en transmission.

Les vitrages selon l'invention présentent à la fois un facteur solaire inférieur ou égal à 0,31 et/ou une réflexion extérieure au moins supérieure à 35 %. Ces vitrages ont également des couleurs en transmission plus neutres et un aspect argent brillant en réflexion extérieure.

## Revendications

1. Matériau comprenant un substrat transparent revêtu d'un empilement de couches minces comprenant une seule couche métallique fonctionnelle à base d'argent, l'empilement comprenant en partant du substrat :
- un revêtement diélectrique comportant au moins une couche diélectrique,
- éventuellement une couche de blocage inférieure située en-dessous et au contact de la couche métallique fonctionnelle à base d'argent,
- une couche métallique fonctionnelle à base d'argent,
- une couche de blocage supérieure située au-dessus et au contact de la couche métallique fonctionnelle à base d'argent,
**caractérisé en ce que** :
- l'épaisseur du revêtement diélectrique situé en-dessous de la couche métallique fonctionnelle à base d'argent est inférieure à 30 nm,
- la couche de blocage supérieure est une couche à base de nickel et/ou de chrome et présente une épaisseur supérieure à 2,0 nm,
- l'épaisseur de la couche de blocage supérieure est supérieure ou égale à l'épaisseur de la couche de blocage inférieure si une telle couche est présente,
- la somme des épaisseurs de la ou des couches de blocage choisies parmi les couches métalliques à base de nickel et/ou de chrome situées directement au-contact de la couche fonctionnelle à base d'argent est comprise entre 3,0 et 10,0 nm,
le matériau présente une réflexion lumineuse côté extérieur supérieure à 30 %.

2. Matériau selon la revendication 1 **caractérisé en ce que** la couche métallique fonctionnelle à base d'argent présente une épaisseur supérieure à 10 nm.

3. Matériau selon l'une quelconque des revendications précédentes **caractérisé en ce que** les couches de blocage à base de nickel et/ou de chrome comprennent au moins 95 %, en masse de nickel et/ou de chrome par rapport à la masse totale de la couche de blocage.

4. Matériau selon l'une quelconque des revendications précédentes **caractérisé en ce que** la couche de blocage supérieure présente une épaisseur comprise entre 2,1 et 6,0 nm.

5. Matériau selon l'une quelconque des revendications précédentes **caractérisé en ce que** la couche de blocage inférieure présente une épaisseur comprise entre 0,5 et 2,5 nm.

6. Matériau selon l'une quelconque des revendications précédentes **caractérisé en ce que** l'épaisseur du revêtement diélectrique situé en-dessous de la couche métallique fonctionnelle à base d'argent est inférieure à 20 nm.

7. Matériau selon l'une quelconque des revendications précédentes **caractérisé en ce que** l'épaisseur du revêtement diélectrique situé au-dessus de la couche métallique fonctionnelle à base d'argent est supérieure à 30 nm.

8. Matériau selon l'une quelconque des revendications précédentes **caractérisé en ce que** le revêtement diélectrique situé en-dessous et/ou au-dessus de la couche métallique fonctionnelle à base d'argent comprend au moins une couche diélectrique à base de nitrure ou d'un oxynitrure de silicium et/ou d'aluminium.

9. Matériau selon l'une quelconque des revendications précédentes, **caractérisé en ce que** le revêtement diélectrique situé en-dessous de la couche métallique fonctionnelle à base d'argent comportent une seule couche constituée d'un nitrure ou d'un oxynitrure d'aluminium et/ou de silicium, d'épaisseur comprise entre 10 et 30 nm.

10. Matériau selon l'une quelconque des revendications précédentes, **caractérisé en ce que** l'empilement comprend une couche de protection.

11. Matériau selon l'une quelconque des revendications précédentes tel que le substrat est en verre, notamment silico-sodo-calcique ou en matière organique polymérique.

12. Matériau selon l'une quelconque des revendications précédentes, caractérisé en qu'il présente une transmission lumineuse inférieure à 50 % et/ou une réflexion lumineuse côté extérieur supérieure à 35 %.

13. Procédé d'obtention d'un matériau selon l'une quelconque des revendications précédentes, dans lequel on dépose les couches de l'empilement par pulvérisation cathodique magnétron.

14. Vitrage comprenant au moins un matériau selon l'une des revendications 1 à 12 précédentes.

15. Vitrage selon la revendication précédente **caractérisé en ce que** l'empilement est positionné dans le vitrage de sorte que la lumière incidente provenant de l'extérieur traverse le première revêtement diélectrique avant de traverser la première couche métallique fonctionnelle.

## Patentansprüche

1. Material mit einem transparenten Substrat, das mit einer Vielzahl von dünnen Schichten überzogen ist, die eine einzige metallische Funktionsschicht auf Silberbasis umfasst, wobei die Vielzahl ausgehend vom Substrat umfasst:
- einen dielektrischen Überzug, der mindestens eine dielektrische Schicht umfasst,
- gegebenenfalls eine untere Blockerschicht, die unter und in Kontakt mit der metallischen Funktionsschicht auf Silberbasis gelegen ist,
- eine metallische Funktionsschicht auf Silberbasis,
- eine obere Blockerschicht, die über und in Kontakt mit der metallischen Funktionsschicht auf Silberbasis gelegen ist,
**dadurch gekennzeichnet, dass**:
- die Dicke des dielektrischen Überzugs, der unter der metallischen Funktionsschicht auf Silberbasis gelegen ist, weniger als 30 nm beträgt,
- die obere Blockerschicht eine Schicht auf Nickel- und/oder Chrombasis ist und eine Dicke von mehr als 2,0 nm aufweist,
- die Dicke der oberen Blockerschicht größer als oder gleich der Dicke der unteren Blockerschicht ist, sofern eine solche Schicht vorliegt,
- die Summe aus den Dicken der Blockerschicht oder der Blockerschichten, die unter den metallischen Schichten auf Nickel- und/oder Chrombasis gewählt sind, die direkt in Kontakt mit der Funktionsschicht auf Silberbasis gelegen sind, zwischen 3,0 und 10,0 nm beträgt,
das Material eine außenseitige Lichtreflexion von mehr als 30 % aufweist.

2. Material nach Anspruch 1, **dadurch gekennzeichnet, dass** die metallische Funktionsschicht auf Silberbasis eine Dicke von mehr als 10 nm aufweist.

3. Material nach einem der vorhergehenden Ansprüche, **dadurch gekennzeichnet, dass** die Blockerschichten auf Nickel- und/oder Chrombasis mindestens 95 Masse-% Nickel und/oder Chrom bezogen auf die Gesamtmasse der Blockerschicht umfassen.

4. Material nach einem der vorhergehenden Ansprüche, **dadurch gekennzeichnet, dass** die obere Blockerschicht eine Dicke zwischen 2,1 und 6,0 nm aufweist.

5. Material nach einem der vorhergehenden Ansprüche, **dadurch gekennzeichnet, dass** die untere Blockerschicht eine Dicke zwischen 0,5 und 2,5 nm aufweist.

6. Material nach einem der vorhergehenden Ansprüche, **dadurch gekennzeichnet, dass** die Dicke des dielektrischen Überzugs, der unter der metallischen Funktionsschicht auf Silberbasis gelegen ist, weniger als 20 nm beträgt.

7. Material nach einem der vorhergehenden Ansprüche, **dadurch gekennzeichnet, dass** die Dicke des dielektrischen Überzugs, der über der metallischen Funktionsschicht auf Silberbasis gelegen ist, mehr als 30 nm beträgt.

8. Material nach einem der vorhergehenden Ansprüche, **dadurch gekennzeichnet, dass** der dielektrische Überzug, der unter und/oder über der metallischen Funktionsschicht auf Silberbasis gelegen ist, mindestens eine dielektrische Schicht auf der Basis von Silicium- und/oder Aluminiumnitrid oder eines Silicium- und/oder Aluminiumoxinitrids umfasst.

9. Material nach einem der vorhergehenden Ansprüche, **dadurch gekennzeichnet, dass** der dielektrische Überzug, der unter der metallischen Funktionsschicht auf Silberbasis gelegen ist, eine einzige, aus einem Aluminium- und/oder Siliciumnitrid oder einem Aluminium- und/oder Siliciumoxinitrid bestehende Schicht mit einer Dicke zwischen 10 und 30 nm umfasst.

10. Material nach einem der vorhergehenden Ansprüche, **dadurch gekennzeichnet, dass** die Vielzahl eine Schutzschicht umfasst.

11. Material nach einem der vorhergehenden Ansprüche, wobei das Substrat aus Glas, insbesondere aus Kalk-Natron-Silikatglas, oder aus organischem polymerischem Stoff besteht.

12. Material nach einem der vorhergehenden Ansprüche, **dadurch gekennzeichnet, dass** es eine Lichttransmission von weniger als 50 % und/oder eine außenseitige Lichtreflexion von mehr als 35 % aufweist.

13. Verfahren zum Erhalten eines Materials nach einem der vorhergehenden Ansprüche, bei dem die Schichten der Vielzahl aufgesputtert werden.

14. Verglasung mit mindestens einem Material nach einem der vorhergehenden Ansprüche 1 bis 12.

15. Verglasung nach dem vorhergehenden Anspruch, **dadurch gekennzeichnet, dass** die Vielzahl in der Verglasung so positioniert ist, dass das von außen kommende einfallende Licht den ersten dielektrischen Überzug durchquert, bevor es die erste metallische Funktionsschicht durchquert.

## Claims

1. A material comprising a transparent substrate coated with a stack of thin layers comprising just one silver-based functional metal layer, the stack comprising, starting from the substrate:
- a dielectric coating comprising at least one dielectric layer,
- optionally, a lower blocking layer located below and in contact with the silver-based functional metal layer,
- a silver-based functional metal layer,
- an upper blocking layer located above and in contact with the silver-based functional metal layer,
**characterized in that**:
- the thickness of the dielectric coating located below the silver-based functional metal layer is less than 30 nm,
- the upper blocking layer is a layer based on nickel and/or on chromium and exhibits a thickness of greater than 2.0 nm,
- the thickness of the upper blocking layer is greater than or equal to the thickness of the lower blocking layer, if such a layer is present,
- the sum of the thicknesses of the blocking layer or layers chosen from metal layers based on nickel and/or on chromium located directly in contact with the silver-based functional layer is between 3.0 and 10.0 nm
the material presents a light reflection at the external side higher than 30%.

2. The material as claimed in claim 1, **characterized in that** the silver-based functional metal layer exhibits a thickness of greater than 10 nm.

3. The material as claimed in either one of the preceding claims, **characterized in that** the blocking layers based on nickel and/or on chromium comprise at least 95% by weight of nickel and/or of chromium, with respect to the total weight of the blocking layer.

4. The material as claimed in any one of the preceding claims, **characterized in that** the upper blocking layer exhibits a thickness of between 2.1 and 6.0 nm.

5. The material as claimed in any one of the preceding claims, **characterized in that** the lower blocking layer exhibits a thickness of between 0.5 and 2.5 nm.

6. The material as claimed in any one of the preceding claims, **characterized in that** the thickness of the dielectric coating located below the silver-based functional metal layer is less than 20 nm.

7. The material as claimed in any one of the preceding claims, **characterized in that** the thickness of the dielectric coating located above the silver-based functional metal layer is greater than 30 nm.

8. The material as claimed in any one of the preceding claims, **characterized in that** the dielectric coating located below and/or above the silver-based functional metal layer comprises at least one dielectric layer based on a nitride or on an oxynitride of silicon and/or of aluminum.

9. The material as claimed in any one of the preceding claims, **characterized in that** the dielectric coating located below the silver-based functional metal layer comprises just one layer consisting of a nitride or of an oxynitride of aluminum and/or of silicon, with a thickness of between 10 and 30 nm.

10. The material as claimed in any one of the preceding claims, **characterized in that** the stack comprises a protective layer.

11. The material as claimed in any one of the preceding claims, such that the substrate is made of glass, in particular soda-lime-silica glass, or of a polymeric organic substance.

12. The material as claimed in any one of the preceding claims, **characterized in that** it exhibits a light transmission of less than 50% and/or a light reflection on the exterior side of greater than 35%.

13. A process for obtaining a material as claimed in any one of the preceding claims, in which the layers of the stack are deposited by magnetron cathode sputtering.

14. A glazing comprising at least one material as claimed in one of the preceding claims 1 to 12.

15. The glazing as claimed in the preceding claim, **characterized in that** the stack is positioned in the glazing so that the incident light originating from the outside passes through the first dielectric coating before passing through the first functional metal layer.
